Europäisches Patentamt

European Patent Office

Office européen des brevets

(19)

(11) Veröffentlichungsnummer: **0 109 557**
A1

(12) **EUROPÄISCHE PATENTANMELDUNG**

(21) Anmeldenummer: 83110467.4

(22) Anmeldetag: 20.10.83

(51) Int. Cl.³: **H 05 K 7/18**
**H 05 K 7/20**

(30) Priorität: 26.10.82 DE 8230004 U

(43) Veröffentlichungstag der Anmeldung:
30.05.84 Patentblatt 84/22

(84) Benannte Vertragsstaaten:
CH DE FR GB IT LI

(71) Anmelder: INTER CONTROL Hermann Köhler Elektrik
GmbH u. Co. KG
Schafhofstrasse 30
D-8500 Nürnberg(DE)

(72) Erfinder: Hollweck, Walter
Dormitzerstrasse 3
D-8500 Nürnberg(DE)

(74) Vertreter: Tergau, Enno et al,
Hefnersplatz 3 Postfach 11 93 47
D-8500 Nürnberg 11(DE)

(54) Gehäuse für wärmeentwickelnde Bauelemente.

(57) Um ein Gehäuse (1) für wärmeentwickelnde Bauelemente, insbesondere Elektronikteile, wie Moduln, Leiterplatten (2) u.dgl. mit aus mindestens einem Strangpreßprofil (3) gebildeten Wänden (4), Boden (5) und Deckfläche (6), dessen einzelne Gehäuseteile im Bereich ihrer durch Extrusion gebildeten Kanten (7) im Endmontagezustand gegenseitig ineinander eingreifende Nut- und Federelemente (8,9) aufweisen, derart auszubilden, daß es in lose vormontiertem Zustand bereits zur Aufnahme und zum Einschub der Elektronikteile, nämlich Leiterplatten geeignet ist, haben die Nut- und Federelement (8,9) L-, T- oder schwalbenschwanzförmigen Querschnitt und sind ineinander einschiebbar. Dadurch wird erreicht, daß der lediglich lose zusammengeschobene Profilverbund bereits ein ausreichend steifes Gehäuse ergibt und ein radiales Auseinanderfallen der Gehäuseteile vermieden wird.

FIG.1

EP 0 109 557 A1

Gehäuse für wärmeentwickelnde Bauelemente

Die Erfindung betrifft ein Gehäuse für wärmeentwickelnde Bauelemente mit den Merkmalen des Oberbegriffes des Anspruches 1.

Es ist ein Gehäuse der genannten Art bekannt, dessen Gehäusewandungen aus einem flachen Bodenteil und einem im Schnitt U-förmig ausgebildeten Oberteil bestehen. Bodenteil und Oberteil greifen mittels Nut- und Federelementen ineinander und können in Längsrichtung des Gehäuses, das heißt in Längsrichtung der Nut- und Federelemente, gegeneinander verschoben werden. Um die beiden Teile aneinander zu befestigen, muß mindestens eines der gehäuseendseitigen Deckteile auf das durch Bodenteil und Oberteil gebildete Gehäuserohr aufgesetzt werden. Die Befestigung des/der Deckteile erfolgt mittels Schrauben, die in Löcher an den stirnseitigen Schnittflächen der aus extrudierten Aluminiumprofilen bestehenden Boden- und Oberteile eingebracht sind. Durch die Deckteile wird der Zusammenhalt der Boden- und Oberteile mittelbar vollzogen.

Der Erfindung liegt die Aufgabe zugrunde, ein vielseitig einsetzbares Gehäuse zu schaffen, das in lose vormontiertem Zustand bereits zur Aufnahme und zum Einschub von Elektronikteilen wie Moduln und dergleichen geeignet ist. Der Zusammenhalt soll zur Montagevereinfachung mit wenigen Handgriffen erreichbar sein, das Gehäuse jedoch bereits im Vormontagezustand ein insich steifes Ganzes bilden, daß zumindest ein probeweiser Einbau von Einschubplatinen problemlos vollzogen werden kann. Diese Aufgabe wird durch das Kennzeichen des Anspruches 1 gelöst.

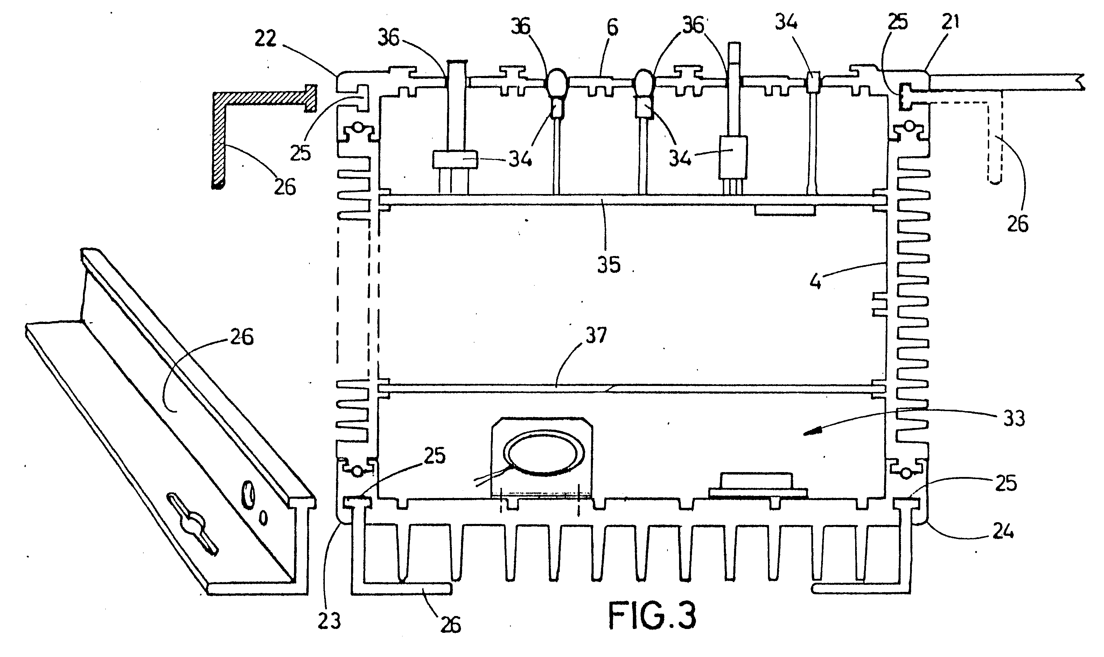

Als Kern der Erfindung wird zunächst angesehen, mit nur wenigen Handgriffen ein Elektronikgehäuse zu schaffen, das - abhängig von der Art (Breite, Länge, Höhe) der eingesetzten Teile - unterschiedlichsten Anforderungen genügt. Insbesondere sollen beispielsweise unterschiedliche Frontplatten mit identischen oder unterschiedlichen Seiten- und Bodenteilen kombinierbar sein. Dies wird dadurch erreicht, daß in Längsrichtung ihrer Kanten die durch Extrusion gebildeten Gehäuseteile mit Nut- und Federelementen versehen sind, die durch gegenseitiges Auf- und Einschieben in Extrusionsrichtung ineinander eingefügt werden können, wobei der zusammengeschobene Profilverbund bereits ein ausreichend steifes Gehäuse ergibt. Durch die L-, T- oder schwalbenschwanzförmigen Nut- und Federelemente wird ein radiales Auseinanderfallen der Gehäuseteile vermieden. Ein solches Gehäuse ist bereits leicht handhabbar und insbesondere zum Einschub von Modulkarten geeignet, die in der Regel zwischen zwei sich peripher gegenüberliegenden Gehäuseseitenwänden in innen an diesen angeordneten Nuten gehalten werden (steckbar gelagert sind). Sollen in einer Gehäusefrontwandung Bauteile wie Lampen, Schalter u.dgl. angeordnet werden, so kann dies dadurch geschehen, daß in die Gehäusewandung lediglich die Ausnehmungen zum Durchgriff der Bauteile eingebracht werden, die Bauteile selbst jedoch auf einer gesonderten Platine befestigt werden können, die in Parallelanlage zur Innenseite der Gehäusewandung gebracht und zusammen mit dieser in die Seitenteile eingeschoben wird. Unmittelbar nach dem Einschub ist die Parallellage von Gehäusewandung und Platine gesichert (eine derartige Konstellation ist in Fig. 3 dargestellt).

Stark wärmeentwickelnde Bauteile wie Netztransformatoren, Leistungstransistoren u.dgl. können zudem unmittelbar an die Innenseiten der stranggepreßten Gehäuseteile in gutem Wärmekontakt mit diesen angebracht werden, was bei noch nicht zusammengeschobenen Gehäuseteilen besonders leicht möglich ist. Die mehr oder weniger vorkonfektionierten Wandungsteile oder Bauteilgruppen werden dann ineinandergefügt, wodurch ein erster Zusammenhalt gegeben und gleichzeitig eine elektrische Masseverbindung gelegt ist. Zudem nimmt ein derartiges Gehäuse in zerlegtem Zustand nur ein Minimum an Verpackungs- oder Lagerraum ein, da es aus flachen Gehäuseplatten ausgebildet werden kann.

Wenn - wie durch Anspruch 2 vorgeschlagen - eine Mehrzahl von Nut- und Federelementen im Bereich der durch Extrusion gebildeten Gehäuseelementkanten vorgesehen ist, können die flachen Profile in einer Vielzahl von unterschiedlichen Anordnungen ineinandergesteckt werden, so daß sich Gehäuse auch komplizierter Formgebung erzielen lassen (z.B. Pultgehäuse). Vorzugsweise sollen dabei die Eingriffsrichtungen von Nut und Federn an jeweils einer Kante Winkel von 90°, 180° oder 270° einschließen, da dann die gegenseitig verbundenen Gehäuseteile im wesentlichen rechtwinklig zueinander ausgerichtet sind. Sind beispielsweise zwei oder mehr Nut- und Federelemente an einer Kante angeordnet, so können mehrere nebeneinanderliegende Gehäusezellen zu einem Gehäuseverbund zusammengestellt werden. Dies hat den Vorteil, daß dann beispielsweise eine elektrisch abschirmende Trennung zwischen störempfindlichen elektronischen Bauteilen (beispielsweise Speicherbausteinen) und notwendigen Netzteilen vorgenommen werden kann, welch letztere sich insbesondere als Störer der erstgenannten Speicher erwiesen haben.

Werden die Halteelemente gemäß Anspruch 4 als in im Bereich der gegenseitigen Anlagestoßfugen angeordnete Schraublöcher eingedrehte selbstschneidende Schrauben ausgebildet, so wird dadurch zum einen ein Aufspreizen der Stoßfugen erreicht, wodurch sich die gegenseitig aufgeschobenen Gehäuseteile ohne Montageschablone selbsttätig immer wieder rechtwinklich ausrichten. Zum anderen wird - bei hochempfindlicher Elektronik von ganz wesentlicher Bedeutung - durch das Selbstschneiden der Schrauben in das Fleisch der Aluminium-Strangpressprofile eine hervorragende elektrische Verbindung zwischen den einzelnen Gehäusewänden geschaffen, wobei Lack- und/oder Eloxalschichten nicht isolierend wirken können, da sie von den selbstschneidenden Schrauben durchgriffen bzw. durchschnitten werden.

Besonders leicht können die Schrauben in die Stoßfugen zwischen Nutgrund und Stirnseite der Federn eingeschraubt werden, wenn Nutgrund sowie Feder jeweils zwei aneinanderliegende, korrespondierende Halblöcher bilden. Der Innendurchmesser der aneinanderliegenden Halblöcher ist kleiner als der Durchmesser der zu verwendenden Schrauben, so daß es zu der innigen, elektrisch gut leitenden Verbindung kommt. Darüber hinaus wird eine hervorragende - weil unmittelbare - mechanische Verbindung zwischen den an sich gegenseitig längsverschieblichen Gehäuseteilen geschaffen, da jeder Gewindegang einer jeden eingeschraubten Schraube (bei einem rechtwinklig ausgebildeten Gehäuse sind vorzugsweise acht Schrauben vorzusehen) an der mechanischen Festigkeit teilhat. Weiterhin ist vorteilhaft, daß die Halblöcher als Profilmulden unmittelbar beim Extrusionsvorgang geformt werden können und somit ein zusätzlicher Fräs- oder Bohrvorgang zur Bildung der Halblöcher entfallen kann.

Gemäß Anspruch 7 werden die selbstschneidenden Schrauben zur Befestigung die das Gehäuse endseitig abschließenden Deckteile herangezogen. Werden zudem selbstschneidende Schrauben verwendet, deren Kopfunterseite mit einer Sicherungsverzahnung versehen ist, die beim Schraubenanzug die Eloxalschicht der Deckteile durchschneidet oder durchkratzt und sich in deren Oberflächen verkeilt, so ist auch zu den Deckteilen eine gute elektrische Verbindung vorhanden.

Durch Anspruch 8 wird die Variabilität des Gehäusesystems weiter gesteigert, da dadurch mit geringem Abstand voneinander mehrere Gehäusezellen aneinandergefügt werden können, wobei beispielsweise der zwischen den Gehäusezellen liegende Raum als mit einem Ventilationsgebläse versehener Lüftungskamin dienen kann. Genauso ist es möglich, daß L-förmige Leisten zusammen mit einem Gehäuseseiten- oder Bodenelement ein vertikal verlaufendes "Hutprofil" bilden, wobei die Leisten die parallelversetzt von dem Mittelteil abstehenden Befestigungsflansche bilden. Wird ein solches Hutprofil an die Seitenwand beispielsweise einer Maschine angesetzt, so wird dadurch ein geschlossener Kamin gebildet.

Durch die Maßnahme gemäß Anspruch 10 wird die Kaminwirkung noch gesteigert, da der Kaminraum in eine Vielzahl von einzelnen Kaminen aufgeteilt ist, wobei die Aufteilung durch die wärmeabführenden Kühlrippen erfolgt. Durch Anspruch 12 wird - in Verbindung mit Anspruch 11 - erreicht, daß eventuelle Unebenheiten der das Gehäuse tragenden Wand- oder Maschinenfläche keine mechanische Beanspruchung bzw. keinen Verzug des aus Einzelelementen gebildeten Gehäuses zur Folge haben. Durch Anspruch 13 wird eine besonders hohe Wärmeabstrahlung des Gehäuses erreicht, Anspruch 14 sorgt für einen intensiven Wärmefluß von den zu kühlenden Bauelementen zu den kaminbildenden Flächen hin. Mit Anspruch 15 ist der "Einschubgedanke" auch auf die Gehäusefrontseite übertragen, da L- und/oder T-förmige Stege auch zum Halten von vorzugsweise beschrifteten Kunststoffolien herangezogen werden können.

Anspruch 16 erlaubt eine Aufteilung des Gehäuseinnenraumes in einem Längs- und/oder Querrastermaß, das durch den gegenseitigen Seitenabstand der Haltenuten festgelegt ist. Neben mit Bauteilen bestückten Platinen können auch metallische mit den Wandprofilen verbundene Zwischenwände zur elektrischen und/oder magnetischen Abschirmung in die Haltenuten eingeschoben werden.

Die durch Anspruch 17 eröffnete Möglichkeit der unterschiedlichen Einfärbung von durch Strangpressprofile gebildeten Gehäuseteile ergibt sich aus dem obigen Baukastengedanken. Es ist nämlich möglich, die Frontplatte (und nur diese!) kontrastreich hell einzufärben, während alle übrigen Gehäuseteile zur Verbesserung der Wärmeabstrahlung dunkel sein können.

Die Erfindung ist anhand einiger Ausführungsbeispiele in den Zeichnungsfiguren näher erläutert.

Es zeigen:

Fig. 1 ein aus Strangpreßprofilen gebildetes Gehäuse in Draufsicht, jedoch mit abgenommenem Deckteil,

Fig. 2 eine Detailansicht einer schwalbenschwanzförmig ausgebildeten Nutfeder-Stoßfuge,

Fig. 3 ein Gehäuse mit modifizierten Nut-/Federanordnungen und L-förmigen Montageleisten,

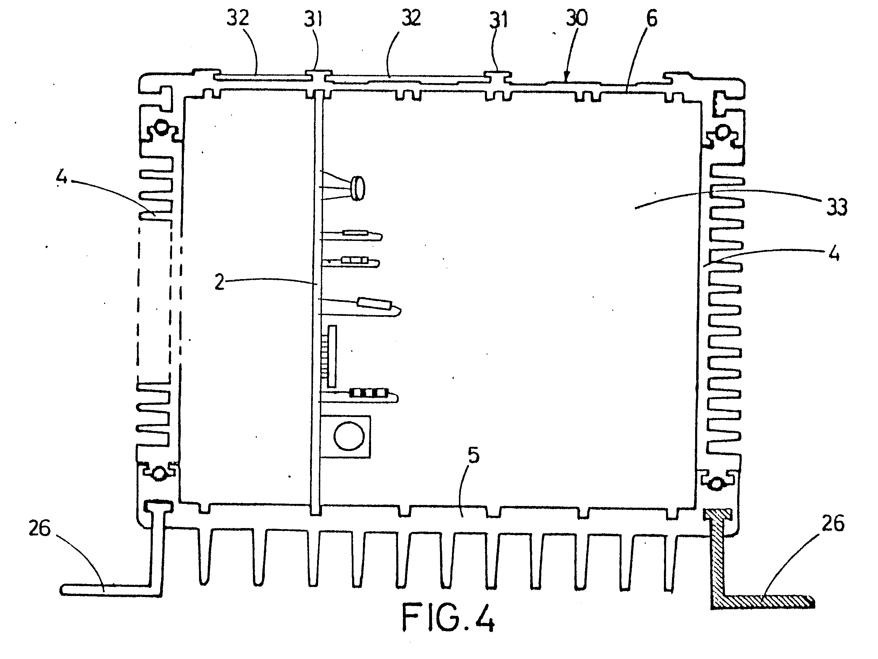

Fig. 4 ein Gehäuse gemäß Anspruch 3, jedoch mit anders eingesetzten L-förmigen Verbindungsleisten,

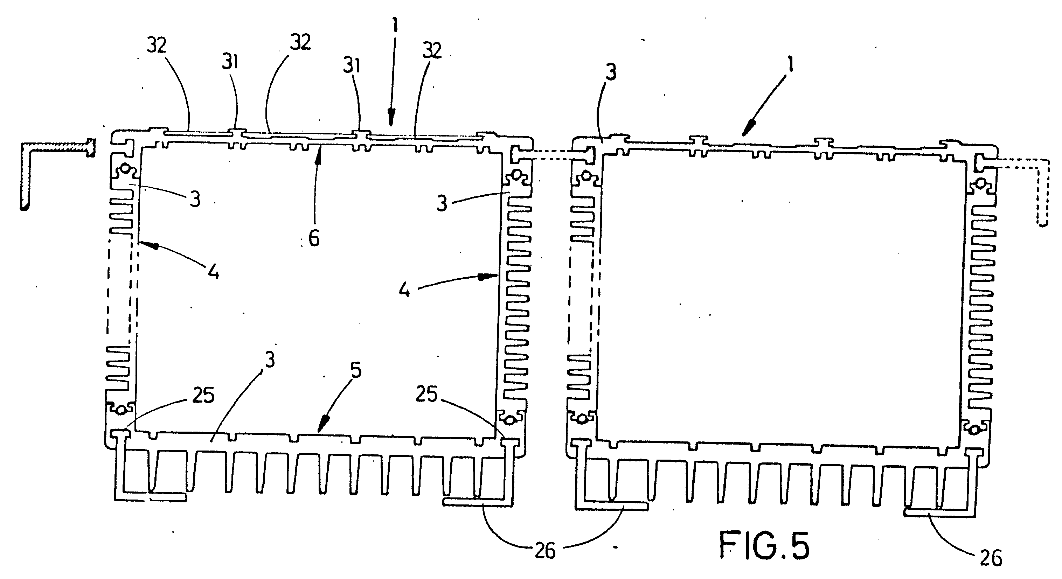

Fig. 5 zwei nebeneinander montierte Gehäuse gemäß Fig. 3,

Fig. 6 zwei nebeneinander montierte Gehäuse gemäß Fig. 3, die zwischen sich einen Lüftungskamin bilden,

Fig. 7 zwei nebeneinander montierte Gehäuse gemäß Fig. 6 mit einer modifizierten Ausbildung der Verbindungsteile.

Das Gehäuse 1 für wärmeentwickelnde Bauelemente wie Moduln, Leiterplatten 2 und dergleichen besteht aus mehreren Strangpreßprofilen 3, die die Wände 4, den Boden 5 und die Deckfläche 6 bilden. Im Bereich ihrer durch Extrusion gebildeten Kanten 7 sind die Strangpreßprofile 3 mit Nutelementen 8 und Federelementen 9 versehen, die entweder einen L-, T- oder schwalbenschwanzförmigen Querschnitt haben, so daß die ineinander eingeführten Nut- und Federelemente 8, 9 abgesehen von ihrer Längsverschieblichkeit bereits im Vormontagezustand fest ineinandergefügt sind.

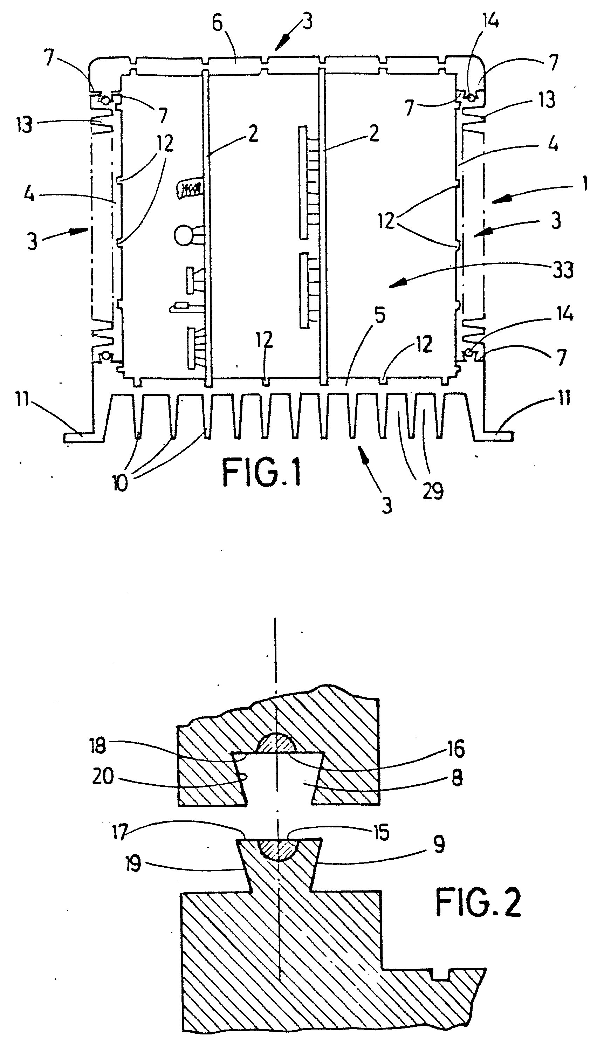

Der Boden 5 ist mit einer Mehrzahl von nach außen abstehenden Kühlrippen versehen, die zwischen zwei L-förmigen Abbildungen 11 angeordnet sind. Die L-förmigen Abbiegungen 11 und die Kühlrippen 10 sind bei dem in Fig. 1 dargestellten Ausführungsbeispiel einstückig mit dem Boden 5 ausgebildet. Die Wände 4 sind ebenfalls mit Kühlrippen 13 versehen, die allerdings kürzer als die Kühlrippen 10 des Bodens sind.

An den Innenseiten der Wände 4, Boden- und Deckfläche 5,6 sind Haltenuten 12 angeordnet, in die die Leiterplatten 2 oder Abschirmplatten eingeschoben werden können.

Um die Strangpreßprofile 3, 4, 5 nach Zusammenfügung in den Vormontagezustand gegen gegenseitige Längsverschiebung zu sichern, sind im Stoßfugenbereich der Nut- und Federelemente 8, 9 Schraublöcher 14 vorgesehen, die durch Halblöcher 15, 16 gebildet werden und in die selbstfurchende Schrauben eingedreht werden können. Beim gezeigten Ausführungsbeispiel sind die Halblöcher 15, 16 in der Frontseite 17 des Federelementes 9 und – korrespondierend dazu – im Nutboden 18 angeordnet. Es liegt genauso im Rahmen der Erfindung, beispielsweise in den Seitenflanken 19, 20 entsprechend korrespondierende Halblöcher vorzusehen. Die Halblöcher sind durch Extrusion gebildet.

Bei dem in Fig. 3 ff. gezeigten Ausführungsbeispiel sind an jeder Gehäuseecke 21-24 zusätzliche Nuten 25 zum Einsatz von L-förmigen Leisten 26 vorgesehen, die entweder als Halteelemente oder Verbindungselemente dienen können.

0109557

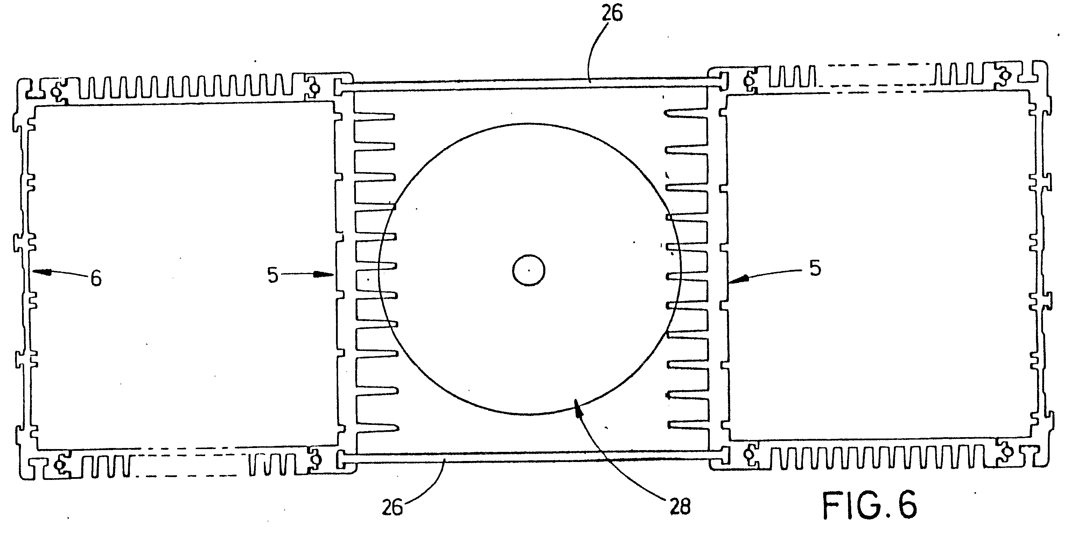

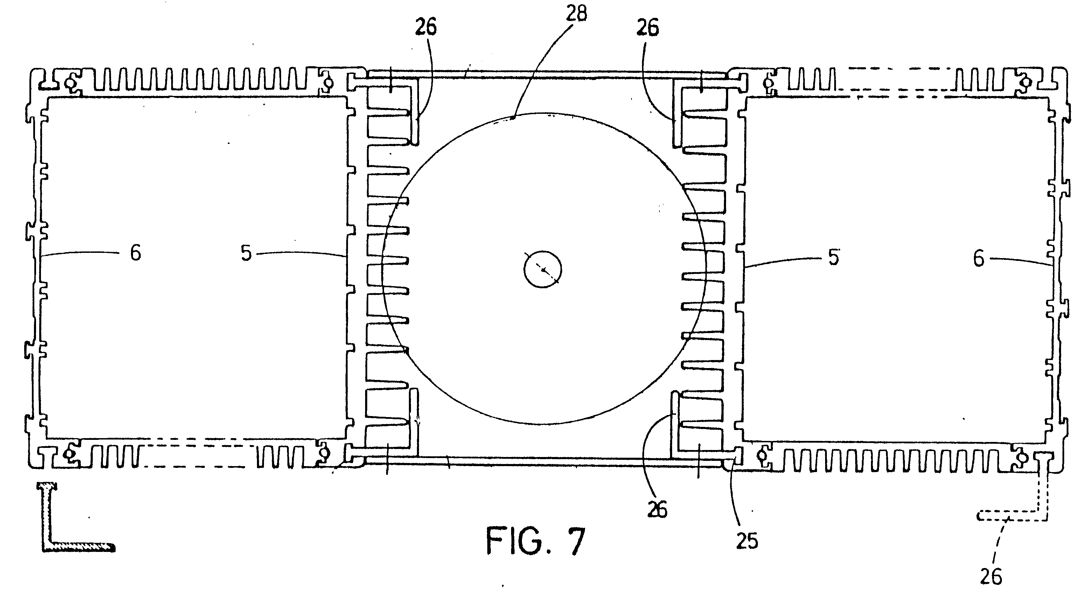

Wie insbesondere Fig. 6 und 7 zeigen, können die Leisten 26 entweder vollständig oder teilweise einen Lüftungskamin 27 bilden, in welchem ein Ventilator angeordnet sein kann, der mit 28 angedeutet ist.

Es ist von Bedeutung, daß entweder die Leisten 26 oder die Abbiegungen 11 gemäß Fig. 1 eine größere Abstehlänge haben, als die zwischen ihnen befindlichen Kühlrippen 10, so daß zwischen einer nicht dargestellten Montagewand und den Abbiegungen 11/Leisten 26 ein von vielen Kühlrippen durchsetzter weiterer Lüftungskamin 29 gebildet wird.

Auf der Außenseite 30 der Deckfläche 6 sind T-förmige Vorsprünge 31 angeordnet, zwischen denen vorzugsweise transparente, mit Aufdrucken versehene Folien 32 gehaltert werden.

Die Leisten 26 sowie die Folien 32 werden durch endseitig auf das Gehäuse 1 aufgeschraubte Deckteile 33 fixiert, die ihrerseits durch die selbstschneidenden Schrauben in Verbindung mit den Halblöchern 15, 16 befestigt sind.

Bei dem in Fig. 3 gezeigten Ausführungsbeispiel sind in der Deckfläche 6 weitere Bauteile 34 angeordnet, die auf einer parallel hinter die Deckfläche eingeschobenen Platine 35 montiert sind und durch Ausnehmungen 36 der Deckfläche 6 greifen. Zur weiteren Aufteilung des Inneraumes des Gehäuses ist eine metallische Abschirmplatte 37 vorgesehen, die in gleicher Weise wie die Platinen in die Haltenuten 12 einschiebbar ist.

0109557

Weiterhin ist in Fig. 3 noch ein Netztrafo 38 dargestellt, der unmittelbar auf dem Boden 5 in gutem Wärmeverbund angeordnet ist und mit dem Boden eine thermisch hoch belastbare Baugruppe bildet.

## Bezugszeichen

| | | | |
|---|---|---|---|
| .1 | Gehäuse | 18 | Nutboden |
| 2 | Leiterplatte | 19 | Seitenflanken |
| 3 | Strangpreßprofil | 20 | Seitenflanken |
| 4 | Wände | 21 | Gehäuseecke |
| 5 | Boden | 22 | Gehäuseecke |
| 6 | Deckfläche | 23 | Gehäuseecke |
| 7 | Kanten | 24 | Gehäuseecke |
| 8 | Nutelemente | 25 | Nuten |
| 9 | Federelemente | 26 | Leisten |
| 10 | Kühlrippen | 27 | Lüftungskamin |
| 11 | Abbiegungen | 28 | Ventilator |
| 12 | Haltenuten | 29 | weiterer Lüftungskamin |
| 13 | Kühlrippen | 30 | Außenseite |
| 14 | Schraublöcher | 31 | Vorsprünge |
| 15 | Halbloch | 32 | Folien |
| 16 | Halbloch | 33 | Deckteile |
| 17 | Frontseite | 34 | weitere Bauteile |
| | | 35 | Platine |
| | | 36 | Ausnehmungen |
| | | 37 | Abschirmplatte |
| | | 38 | Netztrafo |

Patentansprüche

1. Gehäuse 1 für wärmeentwickelnde Bauelemente, insbesondere Elektronikteile wie Moduln, Leiterplatten 2 und dergleichen mit aus mindestens einem Strangpreßprofil 3 gebildeten Wänden 4, Boden 5 und Deckfläche 6, wobei die einzelnen Gehäuseteile im Bereich ihrer durch Extrusion gebildeten Kanten 7 im Endmontagezustand gegenseitig ineinander eingreifende Nut- und Federelemente 8, 9 aufweisen,

dadurch gekennzeichnet,

daß die Nut- und Federelemente 8, 9 L-, T- oder schwalbenschwanzförmigen Querschnitt haben und ineinander einschiebbar sind.

2. Gehäuse nach Anspruch 1,

dadurch gekennzeichnet,

daß eine Mehrzahl von Nut- und Federelementen 8, 9 an den Kanten 7 der Strangpreßprofile 3 vorgesehen sind.

3. Gehäuse nach einem der vorhergehenden Ansprüche 1 oder 2,

dadurch gekennzeichnet,

daß die Eingriffsrichtungen von Nut- und

-2-

Federelementen 8, 9 gleicher Kanten 7 Winkel von 90°, 180° oder 270° einschließen.

4. Gehäuse nach einem der vorhergehenden Ansprüche,

dadurch gekennzeichnet,

daß die Gehäuseteile 4,5,6 in ihrer Montageendstellung durch im Bereich der Nut- und Federelemente 8, 9 in Nutlängsrichtung verlaufende Halteelemente (Schrauben)gegen gegenseitige Längsverschiebung gesichert sind.

5. Gehäuse nach einem der vorhergehenden Ansprüche,

dadurch gekennzeichnet,

daß die Halteelemente als in Schraublöcher 14 eingedrehte selbstschneidende Schrauben ausgebildet sind.

6. Gehäuse nach einem der vorhergehenden Ansprüche,

dadurch gekennzeichnet,

daß die Schraublöcher 14 durch in jedem Strangpreßprofil 3 angeordnete korrespondierende Halblöcher 15, 16 gebildet werden.

7. Gehäuse nach einem der vorhergehenden Ansprüche,

dadurch gekennzeichnet,

daß die selbstschneidenden Schrauben endseitig die gehäuseabschließenden Deckteile 33 durchgreifen.

8. Gehäuse nach einem der vorhergehenden Ansprüche,

dadurch gekennzeichnet,

daß in Nuten 25 als Halte- oder Verbindungselemente gesonderte winkel- oder T-T-förmige Leisten 26 einschiebbar sind.

9. Gehäuse nacheinem der vorhergehenden Ansprüche,

dadurch gekennzeichnet,

daß die Leisten 26 eine Seitenwand eines Lüftungskamins 27 bilden.

10. Gehäuse nach einem der vorhergehenden Ansprüche,

dadurch gekennzeichnet,

daß der mit einer Mehrzahl von nach außen abstehenden Kühlrippen 10 versehene Boden 5 mit den L-förmigen Leisten 26 oder mit an ihm einstückig angeformten Abbiegungen 11 einen vertikal zu montierenden weiteren Lüftungskamin 29 bildet.

11. Gehäuse nach Anspruch 10,

dadurch gekennzeichnet,

daß der weitere Lüftungskamin 29 durch die Kühlrippen 10 in eine Mehrzahl von Einzelkaminen aufgeteilt ist.

12. Gehäuse nach einem der vorhergehenden Ansprüche,

dadurch gekennzeichnet,

daß die im weiteren Kamin 29 befindlichen Kühlrippen 10 kürzer als die Abstehhöhe der Leisten 26 oder Abbiegungen 11 ist.

13. Gehäuse nach einem der vorhergehenden Ansprüche,

dadurch gekennzeichnet,

daß die Wände 4 nach außen weisende weitere Kühlrippen 13 aufweisen.

14. Gehäuse nach einem der vorhergehenden Ansprüche,

dadurch gekennzeichnet,

daß die wärmeentwickelnden Bereiche des in das Gehäuse 1 eingebauten Bauelementes (Leiterplatte 2) bevorzugt im Bereich des Bodens 5 angeordnet sind..

15. Gehäuse nach einem der vorhergehenden Ansprüche,

dadurch gekennzeichnet,

daß an der Außenseite 30 der Deckfläche 6 weitere Vorsprünge 31 zum Haltern von vorzugsweise beschrifteten Folien 32 angeordnet sind.

16. Gehäuse nach einem der vorhergehenden Ansprüche,

dadurch gekennzeichnet,

daß an allen stranggepreßten Gehäusewandungen Haltenuten 12 angeordnet sind.

17. Gehäuse nach einem der vorhergehenden Ansprüche,

dadurch gekennzeichnet,

daß die Deckfläche 6 aus einem hell-eingefärbten Strangpreßprofil 3, die übrigen Gehäuseelemente 4, 5 hingegen aus dunkel eingefärbten Strangpreßprofilen bestehen.

FIG.1

FIG.2

FIG.3

FIG.4

FIG.5

FIG.6

0109557

FIG. 7

0109557

Europäisches
Patentamt

**EUROPÄISCHER RECHERCHENBERICHT**

Nummer der Anmeldung

EP 83 11 0467

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | FR-A-2 179 216 (VERO ELECTRONICS LTD.)<br><br>* Seite 2, Zeile 19 - Seite 4, Zeile 4; Patentansprüche; Abbildungen 1-5 *<br><br>--- | 1,3-5, 10,13, 16 | H 05 K 7/18<br>H 05 K 7/20 |
| X | DE-A-2 629 107 (SIEMENS AG)<br><br>* Seite 5, Zeile 22 - Seite 7, Zeile 8; Patentansprüche 1,2,6,8; Abbildungen 1,2,7-9 *<br><br>--- | 1,3,10 ,14 | |
| X | DE-B-2 161 309 (INGENIEUR-PLANUNGS-GmbH)<br>* Spalte 6, Zeilen 24-63; Ansprüche 1,2,4-6; Abbildungen 1,5 *<br><br>--- | 1,3,16 | |

| | | | RECHERCHIERTE SACHGEBIETE (Int. Cl. ³) |
|---|---|---|---|
| A | US-A-3 909 678 (A.A. RIFKIN et al.)<br>* Insgesamt *<br><br>--- | 1,8-13 | H 05 K<br>F 16 B |
| A | US-A-4 177 499 (W.K. VOLKMANN)<br><br>* Insgesamt *<br><br>--- | 1,10, 11,13, 14 | |
| A | DE-A-1 591 478 (SIEMENS AG.)<br>* Patentansprüche 1-7; Abbildungen 1-4 *<br><br>----- | 1-4 | |

Der vorliegende Recherchenbericht wurde für alle Patentansprüche erstellt.

| Recherchenort | Abschlußdatum der Recherche | Prüfer |
|---|---|---|
| DEN HAAG | 15-02-1984 | VISENTIN A. |